# EUROPEAN PATENT APPLICATION

(11) **EP 4 755 843 A1**
(43) Date of publication of application: **10.06.2026**
(21) Application number: 24217063.7
(22) Date of filing: 03.12.2024
(51) Int. Cl.: B81B 3/00

(54) **MEMS DEVICE WITH INCREASED TILDING ANGLE**

(71) Applicant: Murata Manufacturing Co., Ltd., Nagaokakyo-shi, Kyoto 617-8555 (JP)
(72) Inventor: PARTANEN, Mikko, 01710 Vantaa (FI)
(74) Representative: Boco IP Oy Ab

(57) **Abstract**

The disclosure relates to a MEMS device with in-plane moving structures and translation beams to move a rotating structure out-of-plane, wherein the arrangement of the translation beams contributes to the out-of-plane rotation of the rotating structure. An advantage of the arrangement of the disclosure is that out-of-plane movement to the large tilt angles is achieved with lower voltage in comparison to two-layer tilting structures.

## Description

### FIELD OF THE DISCLOSURE

The present disclosure relates to a MEMS device with a movable part.

### BACKGROUND OF THE DISCLOSURE

Microelectromechanical (MEMS) devices, such as MEMS mirrors or accelerometers, often comprise at least one movable part which needs to be rotated out-of-plane. For example, MEMS mirrors may usually benefit from large out-of-plane tilting displacement to allow wide range of angles or positions. One way to implement out-of-plane rotation is described in a document US2021396993A1. A MEMS device of US2021396993A1 comprises a first layer that includes a stator comb actuator and a second layer that includes a rotor comb actuator, and tilting is achieved by engaging a plurality of teeth of the stator comb actuator with a plurality of teeth of the rotor comb actuator. However, an actuator of US2021396993A1 with the stator and the rotor parts at the different layers would require large electrostatic force to achieve large tilting angles and may restrict tilting angles range. Thus, another solution which does not require excessively large electrostatic forces and allows out-of-plane rotation to the large tilting angles is needed.

### BRIEF DESCRIPTION OF THE DISCLOSURE

An object of the present disclosure is to provide a MEMS device so as to solve the above problem.

The object of the disclosure is achieved by what is stated in the independent claims. Some embodiments of the disclosure are disclosed in the dependent claims.

The disclosure is based on the idea of using an in-plane drive structures and translation beams to move a movable structure out-of-plane. An advantage of the arrangement of the disclosure is that out-of-plane movement to the large tilt angles is achieved with lower voltage in comparison to two-layer tilting structures.

### BRIEF DESCRIPTION OF THE DRAWINGS

In the following the disclosure will be described in greater detail by means of preferred embodiments with reference to the accompanying drawings, in which:
Figure 1a illustrates a schematic of the operating principle of a MEMS device of this disclosure;
Figure 1b illustrates a schematic of an arrangement of connection points at a rotating structure of the MEMS device of this disclosure;
Figure 2a illustrates a MEMS device of this disclosure comprising one driving unit;
Figure 2b illustrates the MEMS device of this disclosure comprising one driving unit and one example of the anti-phase coupler;
Figure 2c illustrates the MEMS device of this disclosure comprising one driving unit and another example of the anti-phase coupler;
Figure 3 illustrates a MEMS device of this disclosure comprising four driving units and two options of translation beams arrangement;
Figure 4a illustrates an example of the MEMS device of this disclosure with a reflector;
Figure 4b illustrates the example of the MEMS device of this disclosure with the reflector and its operating principle;
Figure 5 illustrates an example of a fabrication method of the MEMS device of this disclosure.

The figures are for illustrative purposes only and are not shown in scale.

### DETAILED DESCRIPTION OF THE DISCLOSURE

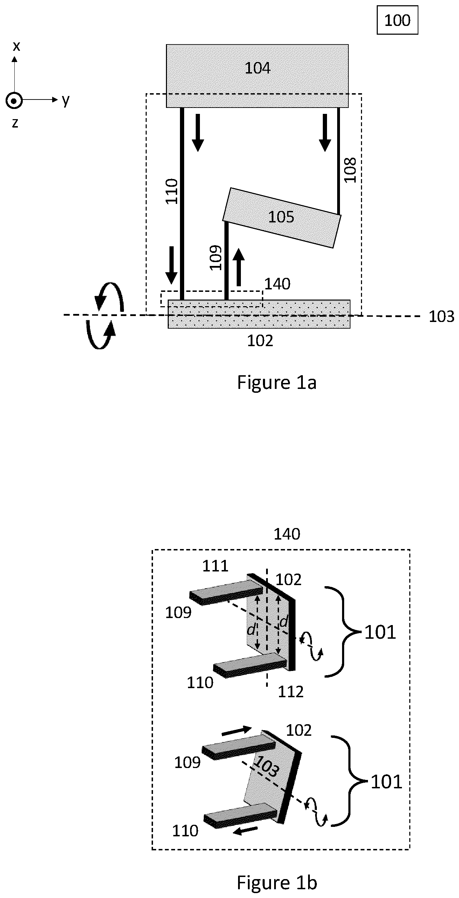

The invention of this disclosure is based on the idea schematically illustrated in Figures 1a and 1b. A rotating structure 102 and a drive structure 104 may be interconnected with a driving system 120. The driving unit may comprise a first translation beam 109 which may extend from the driving structure to the rotating structure. The driving unit may further comprise an anti-phase coupler 105, which at one end may be connected to the drive structure 104 with an in-plane beam 108. On its other end, the in-plane structure may be connected to the rotating structure with a second translation beam 110. The first translation beam and the in-plane beam may transfer the in-plane force from the drive structure to the rotating structure and to the anti-phase coupler correspondingly, if the drive structure is an actuator transducer, which is configured to produce movement.

As illustrated in Figure 1b, the first and the second translation beams may be connected to the rotating structure in two different connection points, such as a first connection point 111 and a second connection point 112. The position of the first and second connection points with relation to a first rotation axis 103 may allow rotation of the rotating structure when the first translation beam 109 and the second translation beam 110 move in opposite directions along x-axis.

Specifically, as Figure 1a illustrates, if the drive structure 104 moves towards the rotating structure 102, the first translation beam 109 and the in-plane beam 108 move in the same negative x-direction and apply force to the first connection point 111 on the rotating structure 102 and on one end of the anti-phase coupler. Force applied to one end 106 of the anti-phase coupler 105 may rotate it in xy-plane. The in-plane rotation of the anti-phase coupler 105 may result in the second translation beam 110 moving in the positive x-direction towards the drive structure 104, which may pull the second connection point 112 on the rotating structure. Pushing of the first connection point 111 and pulling the second connection point 112 on the rotating structure 102 may result in its out-of-xy-plane rotation. Thus, out-of-plane movement of the rotating structure to the large tilt angles may be achieved by the in-plane movement of the drive structure lying in one plane. In addition, such arrangement allows to rotate the rotating structure symmetrically to both sides of the rotation axis and with less driving force while using one drive structure at one side of the rotation axis, which saves the design space. Further, the out-of-plane movement is achieved with lower voltage in comparison to two-layer tilting structures.

A microelectromechanical device comprising a device layer which defines an xy-plane, wherein the xy-plane comprises an x-direction and a vertical direction is perpendicular to the xy-plane, a rotating structure in the device layer, wherein a first rotation axis extends through the rotating structure and lies in the device layer, a drive structure, wherein the drive structure is in the device layer, the drive structure is configured to oscillate in linear motion along the x-direction of the xy-plane, wherein the microelectromechanical device further comprises a driving system, wherein the driving system comprises a first driving unit, which comprises an anti-phase coupler, an in-plane beam, wherein at least one first in-plane beam extends in the x-direction from the drive structure to the anti-phase coupler, a first translation beam, which extends in the x-direction from the drive structure to a first connection point on the rotating structure, and a second translation beam, which extends in the x-direction from the anti-phase coupler to a second connection point on the rotating structure, and wherein z-coordinates of the first connection point and the second connection point in the vertical direction are different from z-coordinate of the first rotation axis in the vertical direction, and wherein the rotating structure is configured to oscillate in rotational motion out of the xy-plane around the first rotation axis.

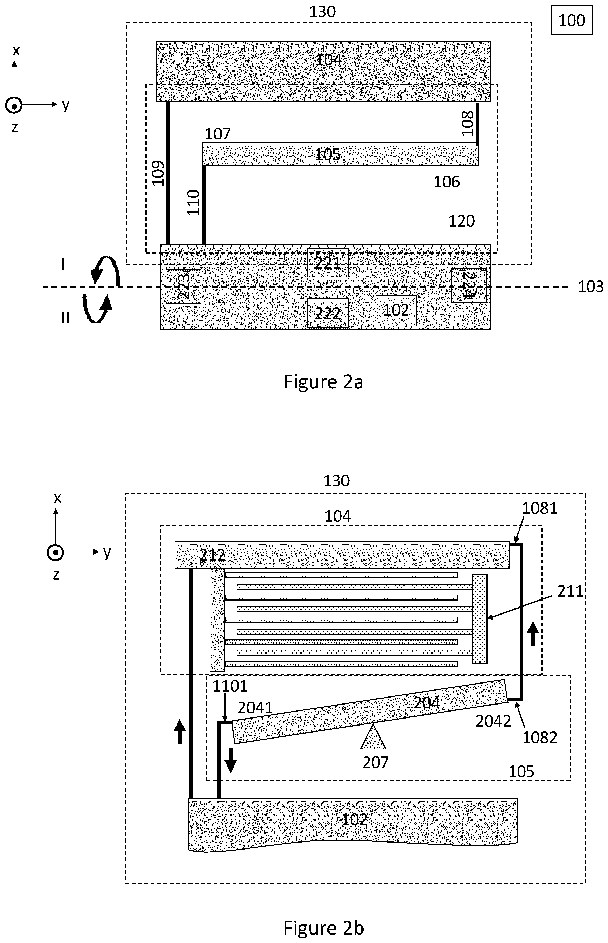

A microelectromechanical (MEMS) device 100 is illustrated in Figure 2Ba. The MEMS device 100 of the Figure 2a may function according to the principle schematically illustrated in Figures 1a and 1b and described above. The MEMS device comprises a device layer 101 (as illustrated in Figure 1b). The device layer 101 comprises all structures shown in Figure 2a. The term "device layer" signifies a combination of layers and structures fabricated in these layers. Specifically, the device layer may comprise multiple layers and structures. The device layer may be parallel to a xy-plane comprised of an x-axis and a y-axis.

Directions which extend parallel to x-axis and y-axis may correspondingly be called an x-direction and a y-direction. Some structures may be rigidly fixed in the device layer. Those fixed structures may be generalized as "a static part of the MEMS device". Some structures may be configured to move in the device layer. Some structures may be configured to move out of the device layer. The thickness of the device layer may be 50 um - 100 um.

A vertical direction of the MEMS device may be defined as a direction perpendicular to the device layer. The vertical direction may extend parallel to z-axis and be called a z-direction.

Words such as "plane", "vertical" and "direction" etc. do not in this disclosure refer to the orientation of the device with regard to the direction of earth's gravitational field either when the device is manufactured or when it is in use. Instead, the word "layer" defines a plane and "vertical" defines a direction which is perpendicular to that plane.

The MEMS device of this disclosure comprises a rotating structure 102, illustrated in Figure 2a. A first rotation axis 103 passes through the rotating structure and lies in the device layer 101. The first rotation axis may pass through the rotation point and through centre of mass (not illustrated) of the movable structure in xz-plane. The rotating structure may comprise four sides: a first side 221 and a second side 222, lying at each side of the first rotating axis, and a third side 223 and a fourth side 224, which may be correspond to each end of the rotating structure along the first rotation axis. Alternatively, the third side and the fourth side may be to the side from the first rotation axis 103. Alternatively, the third side and the fourth side may be parallel to the first rotation axis 103. The first side may be opposite to the second side, and the third side may be opposite to the fourth side.

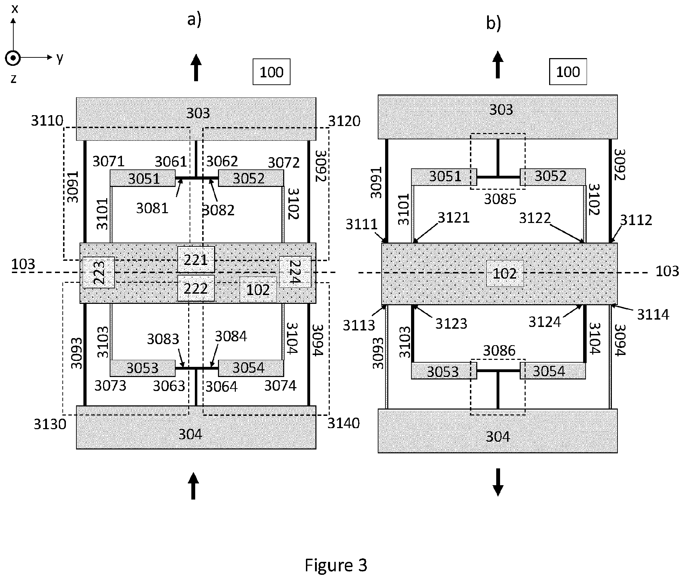

The MEMS structure of this disclosure comprises a drive structure 104. The drive structure is in the device layer. The drive structure is configured to oscillate in linear motion long the x-direction of the device plane. The drive structure is configured to transfer force to other structures of the MEMS structure connected to it. The drive structure may comprise two drive parts: a first drive part on the first side from the first rotation axis 103, and a second drive part on the second side from the first rotation axis 103 (illustrated in Figures 3a and 3b and discussed later). The drive structure may comprise one or more electrostatic transducers, as illustrated in Figure 2b. Specifically, each drive part may comprise one or more electrostatic transducers.

The microelectromechanical device, wherein the drive structure is electrostatic.

The microelectromechanical device, wherein the first drive part and the second drive part each comprise at least one electrostatic comb transducer.

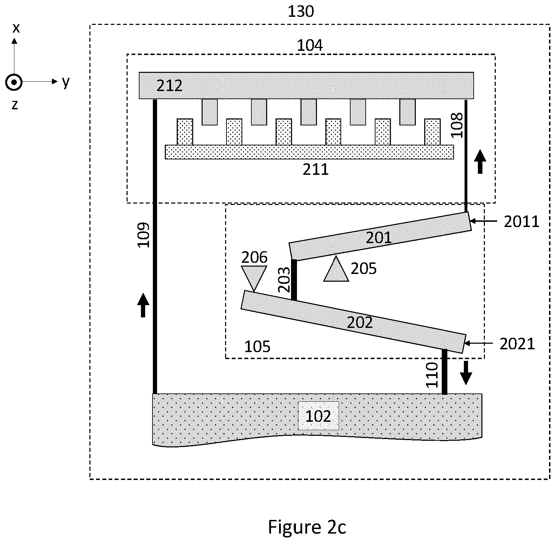

In any example of this disclosure, one or more electrostatic transducers of the drive structure 104 may be electrostatic comb structures as illustrated in Figures 2b and 2c. Each comb structure may comprise a plurality of static comb fingers on a static support structure 211 alternating with a plurality of moving comb fingers on a moving support structure 212. The static comb fingers may be interdigitated with the moving comb fingers.

In the electrostatic comb transducer, the static and moving comb fingers may form comb finger pairs. Each comb finger pair may comprise one static comb finger and one moving comb finger. In the example, illustrated in Figure 2b, when a voltage is applied between the static comb fingers and the moving comb fingers, the moving comb fingers in each comb finger pair may be moving towards the static comb fingers, thus initiating the in-plane movement along x-direction in the xy-plane. The moving comb finger of each fingers pair may be configured to move towards the static comb finger in the same comb fingers pair. The invention may be realized by other comb fingers configurations or types of capacitive transducers.

In the electrostatic comb transducer illustrated in Figure 2c, when a voltage is applied between the static comb fingers and the moving comb fingers, the moving comb fingers in each comb finger pair may be moving between two adjacent static comb fingers, thus initiating the in-plane movement along x-direction in the xy-plane.

The invention may be realized by other comb fingers configurations or types of capacitive transducers.

The MEMS device further comprises a driving system 120, as Figure 2a illustrates. The driving system may comprise one or more driving units. Each of the driving units may comprise multiple parts, such as those which are listed below.

The at least one driving unit of the MEMS device comprises one or more anti-phase coupler 105, which is illustrated in Figure 2a. The anti-phase coupler 105 is configured to move in the device plane, as was explained above with reference to Figure 1a. One or more anti-phase coupler may comprise a first side 106 with a first connection point and a second side 107 with a second connection point. Othe parts of the MEMS device may be connected to one or more anti-phase coupler at the first and second connection points. The anti-phase coupler is configured to flexibly allow movement where the first and second connection points move in thee opposite directions. The anti-phase coupler is configured to stiffly resist movement where the first and second connection points in the same direction.

The anti-phase coupler 105 may extend from the first end to the second end along the y-direction. Alternatively, the anti-phase coupler 105 may extend from the first end to the second end along the x-direction.

The microelectromechanical device of any of the preceding claims, wherein the anti-phase coupler is a single plank which extends along y-direction and comprises a first end and a second end, wherein the first end is opposite to the second end, and wherein the at least one first in-plane beam extends from the first end of the anti-phase coupler, and the second translation beam extends from the second end of the anti-phase coupler, and wherein the anti-phase coupler is suspended at a first suspension point from a first anchor point with a first suspender, which allows the anti-phase coupler to rotate around the first suspension point in the xy-plane .

The anti-phase coupler 105 may be a single plank 204, as illustrated in Figures 2a and 2b. In this configuration, the single plank 204 may be called the single plank anti-phase coupler. The single plank 204 may extend along the y-direction. The single plank may be elongated along the y-direction. A first end 2041 of the single plank along y-direction may correspond to the first side of the anti-phase coupler, while a second end 2042 the plank along y-direction may correspond to the second side of the anti-phase coupler. The first end and the second end of the single plank may be opposite to each other. The first end 2041 of the single plank 204 may be connected to a second translation beam 110 (introduced later in this disclosure). The second end 2042 of the single plank 204 may be connected to an in-plane beam 108 (introduced later in this disclosure). The single plank 204 may be suspended from an anchor point 207 by at least one flexible first suspender (not illustrated in Figure 2b). The anti-phase coupler 105 of Figure 2b may function according to the description with reference to Figure 1a above. The single plank anti-phase coupler may be configured to oscillate in rotational motion in the xy-plane, In other words, the anti-phase coupler of Figure 2b may move as a seesaw in the device plane.

Alternatively, the anti-phase coupler 105 may comprise two planks interconnected together, as illustrated in Figure 2c. A first plank 201 may be interconnected with a second plank 202 with a connection beam 203. A first end 2011 of the first plank 201 may correspond to the first end of the anti-phase coupler 105. A first end 2021 the second plank 202 may correspond to the second end of the anti-phase coupler 105. The first end 2011 of the first plank 201 may be connected to the in-plane beam 108 (introduced later in this disclosure). The first end 2021 of the second plank 202 may be connected to the second translation beam 110 (introduced later in this disclosure). The first plank 201 may be suspended from first anchor point 205 by at least one flexible first suspender (not illustrated in Figure 2c). The second plank 202 may be suspended from a second anchor point 206 by at least one flexible second suspender (not illustrated in Figure 2c). The first and the second anchor points may be at any position along the length of the first and the second plank. The anti-phase coupler 105 of Figure 2c may function so that when the first end 2011 of the first plank 201 is pulled in the positive x-direction, the first end 2021 of the second plank 202 is pulled in the negative x-direction.

Other geometries and other orientations of the anti-phase coupler 105 are also possible.

The at least one driving unit of the MEMS device further comprises one or more in-plane beam 108. One or more in-plane beam 108 extends in the x-direction from the drive structure 204 to the first end 106 of one or more anti-phase coupler 105.

The in-plane beam 108 may be a continuing uninterrupted strip. In other words, the in-plane beam may be a solid beam and have no breaks such as hinges or joints. Alternatively, the in-plane beam may comprise a flexure (such as flexures 1081 and 1082 in Figure 2b) extending in y-direction from the beam to the moving structures (such as moving support structure 212 or single plank 204 of the anti-phase coupler 105). The term "flexure" refers to an etched silicon structure which is sufficiently flexible to absorb, by bending or twisting, the bending moment acting between the moving element and the beam. The in-plane beam may have width in the y-direction significantly smaller than its length in the x-direction. The thickness of the in-plane beam in the z-direction may be same as the thickness of the device layer in the z-direction. The thickness of the in-plane beam may be less than 150 um in the z-direction. The thickness of the in-plane beam may be greater than 50 um in the z-direction. The thickness of the in-plane beam may be 100 um in the z-direction.

The microelectromechanical device, wherein thickness of the in-plane beam is equal to thickness of the device layer.

The at least one driving unit of the MEMS device further comprises one or more first translation beam 109, which extends in the x-direction from the drive structure 104 to a first connection point 111 (illustrated in Figure 1b) on the rotating structure 102. Specifically, one or more first translation beam 109 may be connected to the moving support structure 212 with the moving comb fingers, if the drive structure 104 comprises the electrostatic comb transducer as was described above with reference to Figure 2b.

The at least one driving unit of the MEMS device further comprises one or more second translation beam 110, which extends in the x-direction from the second end of one or more anti-phase coupler to a second connection point 112 (illustrated in Figure 1b) on the rotating structure.

A term "translation beam" may refer to a structure which is configured to transfer force between the rotating structure 102 and the drive structure 104 and between the rotating structure 102 and the anti-phase coupler 105. The translation beam may be a continuing uninterrupted strip. In other words, the translation beam may be a solid beam and have no breaks such as hinges or joints. Alternatively, the in-plane beam may comprise a flexure (such as flexure 1101 in Figure 2b) extending in y-direction from any of the beams to the moving structure(s) (such as single plank 204 of the anti-phase coupler 105).

The translation beam may have width in the y-direction significantly smaller than its length in the x-direction. The thickness of the translation beam in the z-direction may be, at least in some regions, smaller than the thickness of the device layer in the z-direction. The thickness of the translation beam may be less than 25 um, less than 15 um in the z-direction. The thickness of the translation beam may be greater than 2 um, more than 4 um, more than 5 um in the z-direction. The thickness of the translation beam may be 10 um in the z-direction. The thickness of the translation beam may be less than 20%, less than 15% of thickness of the device layer. The thickness of the translation beam may be more than 2%, more than 5% of thickness of the device layer. The thickness of the translation beam may be 10% of thickness of the device layer.

The microelectromechanical device, wherein thickness of the first translation beam and the second translation beam is smaller than of the device layer.

The device layer 101 in the xz-cross section may be recessed to comprise different thicknesses. In particular, the first 109 and the second 110 translation beams may be recessed so that their thickness is smaller in the regions proximal to the rotating structure than in the rest of the device layer. In other words, the first 109 and the second 110 translation beams may be recessed to a recess depth d along the z-direction, as illustrated in Figure 1b. Specifically, the first translation beam 109 may be recessed to the recess depth d in the z-direction and the second 110 translation beam may be recessed to the recess depth d in the negative z-direction, and wise versa. The device layer may be recessed with a recess etching. In the recess etching, some structures of the device layer may be recessed to a certain thickness. In other words, only some depth of the device layer may be etched away in order to achieve the recessed depth d in certain areas of the device layer.

Alternatively, the device layer may be formed of stacked layers, such as a first layer, a second layer and a third layer (not illustrated). The second layer may be between the first and the third layer. The first translation beam 109 and a first part of the rotating structure may be formed in the first layer. A second part of the rotating structure may be formed in the second layer. The second translation beam 110 and a third part of the rotating structure may be formed in the third layer.

In the at least one driving unit of the MEMS device, Z-coordinates of the first connection point 111 and the second connection point 112 in the vertical direction may be different. Specifically, z-coordinates of the first connection point 111 and the second connection point 112 in the vertical direction may be different from z-coordinate of the first rotation axis 103 in the vertical direction.

The arrangement of the drive structure and the at least one driving unit as discussed above, allows the rotating structure 102 to rotate out of the device layer 101, as was explained above with reference to Figures 1a and 1b. Specific operation modes are discussed later in this disclosure.

### More than one driving units

The microelectromechanical device, wherein the drive structure comprises a first drive part at a first side from the rotation axis, and a second drive part at a second side from the rotation axis, and wherein the driving system further comprises a second driving unit, wherein the first driving unit and the second driving unit are on a first side from the first rotation axis, and wherein the first translation beam and the in-plane beam of each the first driving unit and the second driving unit extend from the first drive part, and wherein the at least one driving unit further comprises a third driving unit and a fourth driving unit, wherein the third driving unit and the fourth driving unit are on a second side from the first rotation axis, and wherein the first translation beam and the in-plane beam of each of the third driving unit and the fourth driving unit extend from the second drive part.

The microelectromechanical device, wherein an y-direction is perpendicular to the x-direction, and wherein the anti-phase couplers of each the first driving unit and the second driving unit are coaxially aligned parallel to the y-direction in a non-actuated state, and wherein the anti-phase couplers of each the third driving unit and the fourth driving unit are coaxially aligned parallel to the y-direction in a non-actuated state.

The microelectromechanical device, wherein the first translation beams of the first driving unit and the third driving unit are aligned along the x-direction, and the first translation beams of the second driving unit and the fourth driving unit are aligned along the x-direction.

The microelectromechanical device, wherein the second translation beams of the first driving unit and the third driving unit are aligned with each other along the x-direction, and the second translation beams of the second driving unit and the fourth driving unit are aligned with each other along the x-direction.

The driving system of the MEMS device may comprise more than one driving units, such as illustrated in Figure 3. In this example, the MEMS device may comprise four driving units: a first driving unit 3110, a second driving unit 3120, a third driving unit 3130 and a fourth driving unit 3140, each comprising one anti-phase couple, in-plane beam, the first translation beam and the second translation beam.

As illustrated in Figure 3 a), the first and the second driving units 3110 and 3120 may be aligned along the first side 221 from the first rotating axis. In other words, the first and the second driving units 3110 and 3120 may be aligned along and parallel to the y-direction. The third and the fourth driving units 3130 and 3140 may be aligned along the second side 222 from the first rotating axis. In other words, the third and the fourth driving units 3130 and 3140 may be aligned along and parallel to the y-direction.

The first driving unit 3110 and the third driving unit 3130 may be closer to the third side 223 of the rotating structure. The second driving unit 3120 and the fourth driving unit may be closer to the fourth side 224 of the rotating structure.

The drive structure may comprise two drive parts: a first drive part 303 along the first side 221 of the rotating structure, and a second drive part 304 along the second side 222 of the rotating structure.

On the first side from the first rotation axis 103, the first driving unit 3110 and the second driving unit 3120 may be arranged in the following way:
In the first driving unit 3110, the first translation beam 3091 may extend from the first drive part 303 to the corresponding connection point 3111 at the rotating structure. The second end 3071 of the anti-phase coupler 3051 may be connected to the corresponding connection point 3121 at the rotating structure with the second translation beam 3101. The first end 3061 of the anti-phase coupler 3051 may be connected to the first drive part 303 with the in-plane beam 3081.

In the second driving unit 3120, the first translation beam 3092 may extend from the first drive part 303 to the corresponding connection point 3112 at the rotating structure. The first end 3062 of the anti-phase coupler 3052 may be connected to the first drive part 303 with the in-plane beam 3082. The second end 3072 of the anti-phase coupler 3052 may be connected to the corresponding connection point 3122 at the rotating structure with the second translation beam 3102. Alternatively, the in-plane beams 3081 and 3082 may be merging together into a first single in-plane beam unit 3085, as illustrated in Figure 3 b). The first single in-plane beam unit 3085 may then be connected to the first drive part 303.

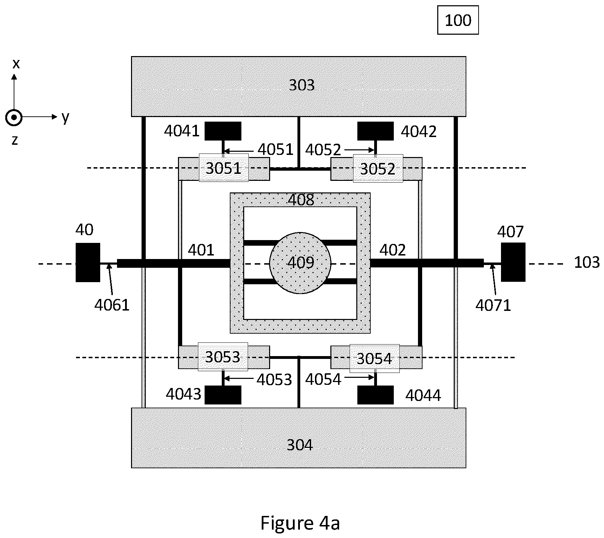

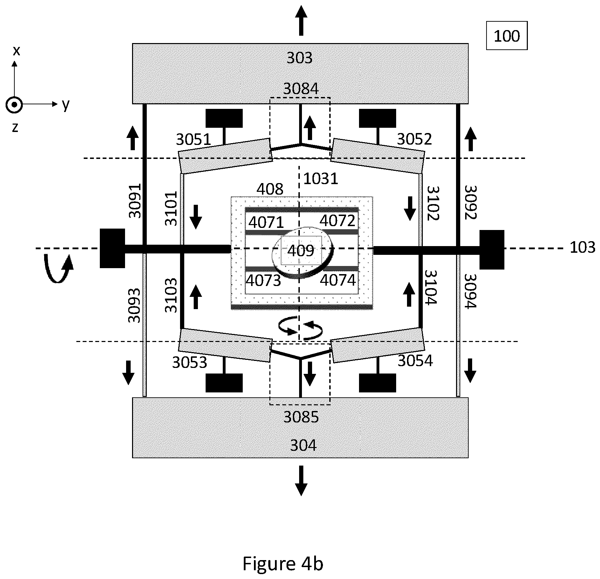

The first translation beams 3091 and 3092 of the first and the second driving units may be aligned with each other along y-direction. The second translation beams 3101 and 3102 of the first and the second driving units may be aligned with each other along y-direction. The anti-phase couplers 3051 and 3052 of of the first and the second driving units may be coaxially aligned and parallel to the y-direction in a non-actuated state, as Figure 4a illustrates. The anti-phase couplers 3051 and 3052 of of the first and the second driving units may be coaxially misaligned an actuated state, as Figure 4b illustrates.

On the second side from the first rotation axis 103, the third driving unit 3130 and the fourth driving unit 3140 may be arranged in the following way:
In the third driving unit 3130, the first translation beam 3093 may extend from the second drive part 304 to the corresponding connection point 3113 at the rotating structure. The second end 3073 of the anti-phase coupler 3053 may be connected to the corresponding connection point 3123 at the rotating structure with the second translation beam 3103. The first end 3063 of the anti-phase coupler 3053 may be connected to the second drive part 304 with the in-plane beam 3083.

In the fourth driving unit 3140, the first translation beam 3094 may extend from the second drive part 304 to the corresponding connection point 3114 at the rotating structure. The first end 3064 of the anti-phase coupler 3054 may be connected to the second drive part 304 with the in-plane beam 3084. The second end 3074 of the anti-phase coupler 3054 may be connected to the corresponding connection point 3124 at the rotating structure with the second translation beam 3104. Alternatively, the in-plane beams 3083 and 3084 may be merging together into a second single in-plane beam unit 3086, as illustrated in Figure 3 b). The second single in-plane beam unit 3086 may then be connected to the second drive part 304.

The first translation beams 3093 and 3094 of the third and the fourth driving units may be aligned with each other along y-direction. The second translation beams 3103 and 3104 of the third and the fourth driving units may be aligned with each other along y-direction. The anti-phase couplers 3053 and 3054 of of the third and the fourth driving units may be coaxially aligned and parallel to the y-direction in a non-actuated state, as Figure 4a illustrates. The anti-phase couplers 3053 and 3054 of of the first and the second driving units may be coaxially misaligned an actuated state, as Figure 4b illustrates.

### Modes of operation

The arrangement of Figure 3, described above, may function in a different manner, depending on at which connection points the first and the second translation beams are connected to the rotating structure 102.

### In-phase movement

The microelectromechanical device, wherein z-coordinates of the first connection point in the first, second, third and fourth driving unit are greater than of the first rotation axis in the vertical direction; and z-coordinates of the second connection point in the first, second, third and fourth driving unit are smaller than of the first rotation axis in the vertical direction.

In the example a) of Figure 3, the first drive part 303 and the second drive part 304 may be configured to linearly move in the same direction along the x-direction. The first drive part 303 may be configured to linearly move in the x-direction. The second drive part 304 may also be configured to linearly move in the x-direction. The directions may also be reversed.

In this arrangement, z-coordinates of the connection points 3111, 3112, 3113 and 3114 may be greater than z-coordinate of the first rotating axis 103. Z-coordinates of the connection points 3121, 3122, 3123 and 3124 may be smaller than z-coordinate of the first rotating axis 103.

In this arrangement, when the first drive part 303 moves in the x-direction, the first translation beams 3091 and 3092 may pull the rotating structure 102, while the second translation beams 3101 and 3102 may push the rotating structure 102, resulting in rotation of the rotating structure 102 around the first rotating axis 103. Since the second drive part may also move in the x-direction, the first translation beams 3093 and 3094 of the third and the fourth driving units may push the rotating structure 102, and the second translation beams 3103 and 3104 may pull the rotating structure 102.

### Anti-phase movement

A microelectromechanical device, wherein z-coordinates of the first connection point in the first and second driving unit and of the second connection point in the third and fourth driving unit are greater than of the first rotation axis in the vertical direction; and z-coordinates of the first connection point in the third and fourth driving unit and of the second connection point in the first and second driving unit are smaller than of the first rotation axis in the vertical direction.

In the example b) of Figure 3, the first drive part 303 and the second drive part 304 may be configured to linearly move in the opposite directions along the x-direction. For example, the first drive part 303 may be configured to linearly move in the x-direction. The second drive part 304 may be configured to linearly move in the negative x-direction. The directions may also be reversed.

In this arrangement, z-coordinates of the connection points 3111, 3112, 3123 and 3124 may be greater than z-coordinate of the first rotating axis 103. Z-coordinates of the connection points 3121, 3122, 3113 and 3114 may be smaller than z-coordinate of the first rotating axis 103.

In this arrangement, when the first drive part 303 moves in the positive x-direction, the first translation beams 3091 and 3092 may pull the rotating structure 102, while the second translation beams 3101 and 3102 may push the rotating structure 102, resulting in rotation of the rotating structure 102 around the first rotating axis 103. Since the second drive part may move in the negative x-direction, the first translation beams 3093 and 3094 of the third and the fourth driving units may pull the rotating structure 102, and the second translation beams 3103 and 3104 may push the rotating structure 102.

### Rotating structure with tilting bars

In any example of this disclosure, the rotating structure 102 may comprise two tilting bars 41 and 42, and a rotating element 403, as illustrated in Figure 4. The tilting bars may be at the opposite sides of the rotating element and may be rigidly fixed to the rotating element. A first tilting bar 401 may be at the first side 221 of the rotating structure and a second tilting bar 402 may be at the second side 222 of the rotating structure. The tilting bars may extend along the first rotation axis 103. The first rotation axis may pass through the centre of the tilting bars in the x-direction and in the z-direction. A first side of each tilting bar may be at the first side from the first rotation axis. A second side of each tilting bar may be at the second side from the first rotation axis.

The width of the first tilting bar 401 and the second tilting bar 402 may be smaller than the width of the rest of the rotating structure 102 in x-direction. Specifically, the width of the first tilting bar 401 and the second tilting bar 402 may be smaller than the width of the rest of the rotating element 403 in x-direction. The purpose of this geometry may be to increase the length of the first translation beam and the in-plane beam, and to bring them closer to the first rotation axis 103. Since the first translation beam and the in-plane beam act as levers, this may result in increasing the torque and increasing the tilting angle of the rotated rotating structure 102.

### Anchoring

As illustrated in Figure 4a, in any example of this disclosure, the anti-phase couplers may be suspended from a first anchor points 4041-4044 by at least one flexible first suspenders 4051-4054 attached to each anti-phase coupler at a first suspension point. The at least one flexible first suspender allows the anti-phase coupler to turn around the first suspension point in the xy-plane.

The first and the second tilting bars 401 and 402 may be suspended from a second anchor points 406 and 407 by at least one flexible second suspenders 4061 and 4071 attached to each tilting bar. Such arrangement may support the rotating structure and reduce its movement in the x- or z-direction

### Example with mirror

The microelectromechanical device, wherein the rotating structure comprises a MEMS mirror.

In any example of this disclosure, the MEMS structure may be a MEMS mirror. In this case, the rotating element 403, may comprise a frame 408, as illustrated in Figure 4a. The rotating element 403 may also comprise a reflector 409. The frame may comprise a second rotation axis 1031 which may be perpendicular to the first rotation axis 103.

The reflector may be suspended inside the frame along the device layer. The reflector may be movable in relation to the frame. The reflector may comprise a reflective coating deposited onto one of its surfaces. The reflective coating may be one or more metal thin film layers, such as aluminium, silver, gold or copper films.

The reflector inside the frame may be independently actuated and rotated around the second rotation axis 1031, as Figure 4b illustrates. At least four piezoelectric actuators 4071-4074 may be inside the frame 408. Each piezoelectric actuator may comprise a piezoelectric layer, such as aluminium nitride, deposited on one actuation spring to facilitate actuation movement. Each piezoelectric actuator is configured to bend out of the frame plane. Each piezoelectric actuator extends from the frame towards the reflector. In other words, each piezoelectric actuator may connect one point at the inside of the frame with one point at the edge of the reflector.

### Operation of MEMS mirror device

The MEMS structure of this disclosure may operate as exemplary illustrated in Figure 4b. If the first drive part 303 moves linearly in the positive x-direction, the first translation beams 3091 and 3092 and in-plane beam unit 3084 (or in-plane beams separately) may also move in the positive x-direction. The first translation beams 3091 and 3092 and in-plane beam unit 3084 (or in-plane beams separately), may pull the first ends of the anti-phase couplers 3051 and 3052 in the positive x-direction to rotate in the xy-plane. The second ends of the anti-phase couplers 3051 and 3052 may push the second translation beams 3101 and 3102 in the negative x-direction. If z-coordinates of the first translation beams 3091 and 3092 at the rotating structure is greater than z-coordinate of the first rotation axis in the vertical direction, and z-coordinates of the second translation beams 3101 and 3102 at the rotating structure is smaller than z-coordinate of the first rotation axis in the vertical direction, the rotating structure may therefore move in the counterclockwise direction.

In this arrangement, the movement on the second side from the rotation axis may support the counterclockwise rotation of the rotating structure. Specifically, if the second drive part 304 moves linearly in the negative x-direction, the first translation beams 3093 and 3094 and the first in-plane beam unit 3085 (or in-plane beams separately) may also move in the negative x-direction. The first translation beams 3093 and 3094 and the first in-plane beam unit 3085 (or in-plane beams separately), may pull the first ends of the anti-phase couplers 3053 and 3054 in the negative x-direction to rotate in the xy-plane. The second ends of the anti-phase couplers 3053 and 3054 may push the second translation beams 3103 and 3103 in the positive x-direction. If z-coordinates of the first translation beams 3093 and 3094 at the rotating structure is smaller than z-coordinate of the first rotation axis in the vertical direction, and z-coordinates of the second translation beams 3103 and 3104 at the rotating structure is greater than z-coordinate of the first rotation axis in the vertical direction, the rotating structure may therefore move in the counterclockwise direction. The direction of rotation may be altered to the clockwise if the first drive part moves in the negative x-direction, and the second drive part moves in the positive x-direction.

The exemplary structure of Figure 4b may also move according to the example discussed with the reference to Figure 3 a), where the first drive part and the second drive part move in the same x-direction. Z-coordinates of the first translation beams and the second translation beams have to be adjusted accordingly.

In the example of Figure 4b, the reflector 409 may be configured to rotate around the second rotation axis 1031. The movement of the frame 408 and the reflector 409 may occur simultaneously and independently from each other.

### Sense combs

In any example of this disclosure, sensing units may be connected to the structures which move in the x-y plane (not illustrated). The sensing units may be configured to detect movement of the structures which move in the x-y plane. The sensing units may be, for example, electrostatic transducers, structurally similar to the electrostatic comb transducer of the drive structure 104 illustrated in Figure 2b.

The electrostatic comb transducer may act as the electrostatic sense transducer when the moving comb finger is moved towards the static comb finger under influence of external force or when the movement is produced by the actuator. The changing distance between the static and moving comb fingers may be used to define voltage change and correspondingly sense the movement.

### Method of fabrication the MEMS device

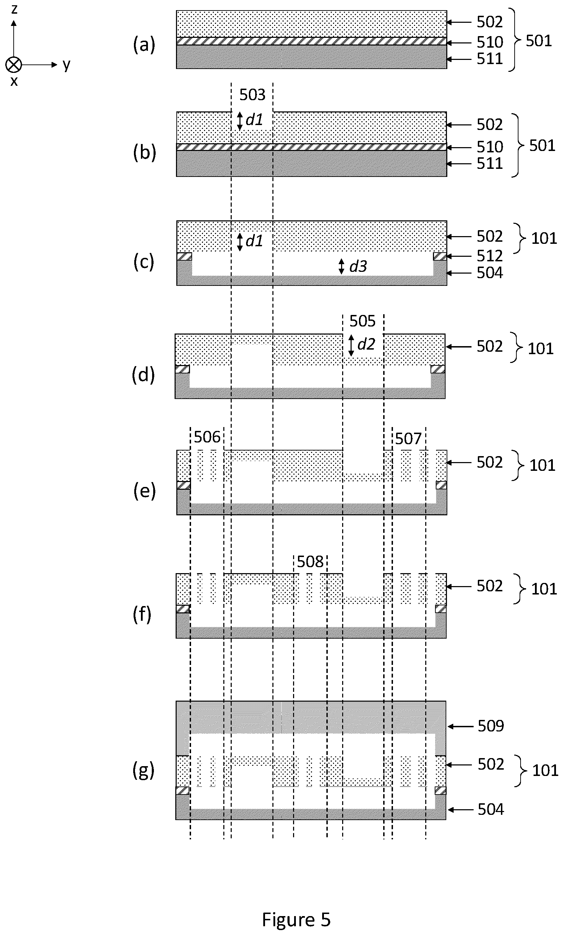

The microelectromechanical device of this disclosure may be fabricated with a method illustrated in Figure 5:
(a) - (b) A top layer 502 of a first wafer 501 may be recessed in a first region 503 to a recess depth *d1* in the z-direction.
(c) The first wafer 501 may be flipped in the z-direction, and the top layer 502 may be attached to a second wafer 504 with layer 512 on top. Layers 511 and 510 may be removed. The second wafer 504 may comprise a cavity of d3 depth, which allows rotation of the structures recessed in the top layer 502. The top layer 502 may form a device layer, which corresponds to the device layer 101 described in this disclosure.
(d) The top layer 502 may be recessed in a second region 505 to a recess depth *d2* in the z-direction.
(e) The top layer 502 may be etched through in a third region 506 and a fourth region 507 to form structured corresponding to the first and the second transducer structures of this disclosure.
(f) Optionally, the top layer 502 may be recessed through in a fifth region 508 to form structured corresponding to a frame and a reflector in the movable structure (described later in this application).
(g) A cap 509 may be attached to the device layer 101 to enclose the top layer 502 between the cap 509 and the second wafer 504. In this arrangement, the structures in the fifth region 508 may have space to rotate without hitting the walls of the surrounding structures.

## Claims

1. A microelectromechanical device comprising:
- a device layer which defines an xy-plane, wherein the xy-plane comprises an x-direction and a vertical direction is perpendicular to the xy-plane,
- a rotating structure in the device layer, wherein a first rotation axis extends through the rotating structure and lies in the device layer,
- a drive structure, wherein the drive structure is in the device layer, the drive structure is configured to oscillate in linear motion along the x-direction of the xy-plane,
wherein the microelectromechanical device further comprises a driving system, wherein the driving system comprises a first driving unit, which comprises:
- an anti-phase coupler,
- an in-plane beam, wherein at least one first in-plane beam extends in the x-direction from the drive structure to the anti-phase coupler,
- a first translation beam, which extends in the x-direction from the drive structure to a first connection point on the rotating structure,
- and a second translation beam, which extends in the x-direction from the anti-phase coupler to a second connection point on the rotating structu re,
- and wherein z-coordinates of the first connection point and the second connection point in the vertical direction are different from z-coordinate of the first rotation axis in the vertical direction,
and wherein the rotating structure is configured to oscillate in rotational motion out of the xy-plane around the first rotation axis.

2. The microelectromechanical device of claim 1, wherein the drive structure is electrostatic.

3. The microelectromechanical device of any of the preceding claims, wherein the anti-phase coupler is a single plank which extends along y-direction and comprises a first end and a second end, wherein the first end is opposite to the second end, and wherein the at least one first in-plane beam extends from the first end of the anti-phase coupler, and the second translation beam extends from the second end of the anti-phase coupler, and wherein the anti-phase coupler is suspended at a first suspension point from a first anchor point with a first suspender, which allows the anti-phase coupler to rotate around the first suspension point in the xy-plane.

4. The microelectromechanical device of any of the preceding claims, wherein the drive structure comprises a first drive part at a first side from the rotation axis, and a second drive part at a second side from the rotation axis,
and wherein
the driving system further comprises a second driving unit, wherein the first driving unit and the second driving unit are on a first side from the first rotation axis, and wherein the first translation beam and the in-plane beam of each the first driving unit and the second driving unit extend from the first drive part,
and wherein
the at least one driving unit further comprises a third driving unit and a fourth driving unit, wherein the third driving unit and the fourth driving unit are on a second side from the first rotation axis, and wherein the first translation beam and the in-plane beam of each of the third driving unit and the fourth driving unit extend from the second drive part.

5. The microelectromechanical device of claim 4, wherein the first drive part and the second drive part each comprise at least one electrostatic comb transducer.

6. The microelectromechanical device of claim 4 or 5, wherein an y-direction is perpendicular to the x-direction, and wherein the anti-phase couplers of each the first driving unit and the second driving unit are coaxially aligned parallel to the y-direction in a non-actuated state, and wherein the anti-phase couplers of each the third driving unit and the fourth driving unit are coaxially aligned parallel to the y-direction in a non-actuated state.

7. The microelectromechanical device of claim 4-6, wherein the first translation beams of the first driving unit and the third driving unit are aligned with each other along the x-direction, and the first translation beams of the second driving unit and the fourth driving unit are aligned with each other along the x-direction.

8. The microelectromechanical device of claim 4-6, wherein the second translation beams of the first driving unit and the third driving unit are aligned along the x-direction, and the second translation beams of the second driving unit and the fourth driving unit are aligned along the x-direction.

9. The microelectromechanical device of any of the preceding claims, wherein thickness of the in-plane beam is equal to thickness of the device layer.

10. The microelectromechanical device of any of the preceding claims, wherein thickness of the first translation beam and the second translation beam are smaller than of the device layer.

11. The microelectromechanical device according to any of the claims 4-10, wherein z-coordinates of the first connection point in the first, second, third and fourth driving unit are greater than of the first rotation axis in the vertical direction; and z-coordinates of the second connection point in the first, second, third and fourth driving unit are smaller than of the first rotation axis in the vertical direction.

12. A microelectromechanical device according to any of the claims 4-10, wherein z-coordinates of the first connection point in the first and second driving unit and of the second connection point in the third and fourth driving unit are greater than of the first rotation axis in the vertical direction; and z-coordinates of the first connection point in the third and fourth driving unit and of the second connection point in the first and second driving unit are smaller than of the first rotation axis in the vertical direction.

13. The microelectromechanical device of any of the preceding claims, wherein the rotating structure comprises a MEMS mirror.
